(19) Europäisches Patentamt
European Patent Office
Office européen des brevets

(11) **EP 2 622 358 B1**

(12) **EUROPÄISCHE PATENTSCHRIFT**

(45) Veröffentlichungstag und Bekanntmachung des Hinweises auf die Patenterteilung:
**08.04.2020 Patentblatt 2020/15**

(21) Anmeldenummer: **11767923.3**

(22) Anmeldetag: **27.09.2011**

(51) Int Cl.:
*G01R 23/02* *(2006.01)* *G01R 23/10* *(2006.01)*

(86) Internationale Anmeldenummer:
**PCT/EP2011/004820**

(87) Internationale Veröffentlichungsnummer:
**WO 2012/041481 (05.04.2012 Gazette 2012/14)**

(54) **VERFAHREN UND ANORDNUNG ZUR FREQUENZBESTIMMUNG**

METHOD AND ARRANGEMENT FOR FREQUENCY DETERMINATION

PROCÉDÉ ET AGENCEMENT POUR LA DÉTERMINATION DE LA FRÉQUENCE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **29.09.2010 DE 102010046880**

(43) Veröffentlichungstag der Anmeldung:
**07.08.2013 Patentblatt 2013/32**

(73) Patentinhaber: **Phoenix Contact GmbH & Co. KG
32825 Blomberg (DE)**

(72) Erfinder: **ZINK, Fabian
32756 Detmold (DE)**

(74) Vertreter: **Bill, Burkart Hartmut
Blumbach - Zinngrebe
Patent- und Rechtsanwälte PartG mbB
Elisabethenstrasse 11
64283 Darmstadt (DE)**

(56) Entgegenhaltungen:
**EP-A2- 1 103 815 FR-A1- 2 566 132
GB-A- 1 539 666 JP-A- 57 096 269
US-A- 4 609 990 US-A- 5 095 264**

**Beschreibung**

Die Erfindung betrifft ein Verfahren zur Bestimmung einer Frequenz eines Eingangssignals sowie eine Anordnung zur Frequenzbestimmung.

US 4 609 990 A beschreibt ein Frequenzmesssystem und ein Verfahren zur Erzeugung eines Signals, das die Frequenz eines Wechselstromsignals repräsentiert. Hierzu wird die Frequenz des Wechselstromsignals am Ende einer Halbwelle bestimmt. Dieses Signal wird zusammen mit einem nachfolgenden ähnlich bestimmten Signal verwendet, um eine Frequenzänderungsrate des Wechselstromsignals zu bestimmen.

US 5 095 264 beschreibt eine Frequenzbestimmung eines periodischen Sensorsignals mittels eines ersten und eines zweiten Zählers, die während abwechselnd steigende und fallende Flanken des Sensorsignals ein Referenztaktsignal zählen. Nach der Summierung der Zählwerte wird einen korrigierten Mittelwert der ersten und zweiten Zählwerte bestimmt, um den Effekt der Modulation des Tastverhältnisses des zu messenden Signals zu kompensieren.

Bei vielen Anwendungen im Bereich der elektronischen Signalverarbeitung ist es notwendig, die Frequenz eines externen anliegenden Eingangssignals zu bestimmen. Bei einem herkömmlichen Verfahren wird beispielsweise bei einem Eingangssignal, das zwei verschiedene Pegelzustände einnehmen kann, die Anzahl von Taktperioden des Referenztaktsignals während einer Periodendauer des Eingangssignals gezählt. Mit dem Zählergebnis kann aus der bekannten Frequenz des Referenztaktsignals die Frequenz des Eingangssignals bestimmt werden. Die so bestimmte Frequenz des Eingangssignals wird beispielsweise als analoger oder digitaler Wert zur weiteren Verarbeitung zur Verfügung gestellt.

Bei einem derartigen Verfahren der Frequenzmessung können jedoch immer wieder Probleme auftreten, wenn es zu Beispielsweise kann eine verbindliche Aussage über die momentan anstehende Frequenz des Eingangssignals nur gemacht werden, wenn mindestens eine Periode des Eingangssignals vollständig durchlaufen ist und ein Ergebnis des Zählers für diese Periode vorliegt. Zudem hängt eine Sprungantwortzeit des gesamten Systems von der Frequenz des Eingangssignals ab, so dass es bei geringen Eingangsfrequenzen von wenigen Hertz zu Antworten des Messsystems von einigen Sekunden kommen kann. Damit ergibt sich bei einem Wechsel der Eingangsfrequenz von beispielsweise mehreren Kilohertz zu wenigen Hertz eine deutliche Verzögerung bei der Bestimmung der Frequenz des Eingangssignals. Diese Verzögerung wird maßgeblich von der neuen Frequenz bestimmt, welche theoretisch auch den Wert 0 Hz annehmen kann. Da in diesem Fall keine vollständige Periode des Eingangssignals mehr bestimmbar ist, kommt es in diesem Fall zu einer unendlichen Sprungantwortzeit des Messsystems. Bei einem Abfall der Frequenz des Eingangssignals kann mit dem herkömmlichen Verfahren die Frequenzbestimmung also erst nach längerer Zeit oder unter Umständen gar nicht zuverlässig bestimmt werden.

Aufgabe der Erfindung ist es daher, ein Verfahren und eine Anordnung zur Frequenzbestimmung eines Eingangssignals anzugeben, die eine zuverlässigere Frequenzbestimmung ermöglichen.

Die Aufgabe wird gelöst mit dem Gegenstand der unabhängigen Patentansprüche. Weiterbildungen und spezielle Ausführungsformen sind Gegenstand der abhängigen Patentansprüche.

In einer Ausführungsform eines Verfahrens zur Bestimmung einer Frequenz eines Eingangssignals wird ein erster Zählwert dadurch bestimmt, dass Taktflanken eines Referenztaktsignals gezählt werden, während das Eingangssignal einem ersten Pegelwert entspricht. Weiterhin wird ein zweiter Zählwert dadurch bestimmt, dass Taktflanken des Referenztaktsignals gezählt werden, während das Eingangssignal einem zweiten Pegelwert entspricht. Die Frequenz wird in Abhängigkeit des ersten und des zweiten Zählwerts bestimmt.

Beispielsweise weist das Eingangssignal zwei Pegelzustände auf, von denen einer einem niedrigen Pegel oder Low-Pegel und der andere einem höheren Pegel oder High-Pegel entspricht. Bei einem analogen Eingangssignal mit kontinuierlichem Schwingungsverlauf, beispielsweise einer Sinusschwingung, können die zwei Signalpegel dadurch bestimmt sein, dass ein vorgegebener Signalwert im Eingangssignal überschritten bzw. unterschritten wird. Die zwei Pegelzustände definieren im zeitlichen Verlauf jeweilige Pegelphasen des Eingangssignals. Zwei aufeinander folgende unterschiedliche Pegelphasen kennzeichnen eine Messperiode. Das Eingangssignal kann auch ein beliebiges Schwingungssignal oder ein oszillierendes Signal sein.

Durch das getrennte Zählen von Taktflanken des Referenztaktsignals während der ersten Pegelphase und der zweiten Pegelphase im Eingangssignal ist es bei dem beschriebenen Verfahren nicht notwendig, für jede Periode im Eingangssignal die volle Periodendauer abzuwarten, um einen Frequenzwert neu bestimmen zu können, sondern es ist möglich, die neue Frequenzbestimmung mit jedem Pegelwechsel im Eingangssignal durchzuführen. Hierbei werden der Frequenzbestimmung beispielsweise jeweils der zuvor bestimmte erste und zweite Zählwert zugrunde gelegt.

Wenn sich die Frequenz des Eingangssignals und damit dessen Periodendauer und die Dauer der ersten und zweiten Pegelphase ändern, nähert sich die Frequenz, die beim ersten Pegelwechsel nach der Frequenzänderung mit dem beschriebenen Verfahren bestimmt wird, der tatsächlichen Frequenz des Eingangssignals an. Beim zweiten Pegelwechsel, also nach Ablauf einer vollen Periode bei der neuen Frequenz des Eingangssignals, liefert die Frequenzbestimmung den tatsächlichen Wert. Somit ist bei dem beschriebenen Verfahren die Zuverlässigkeit der Frequenzbestimmung erhöht.

In einer Ausführungsform des beschriebenen Verfahrens erfolgt die Frequenzbestimmung in Abhängigkeit der Summe des ersten und des zweiten Zählwerts. Bei dieser Ausgestaltung werden der erste und der zweite Zählwert einer Messperiode addiert und beispielsweise ins Verhältnis zu einer bekannten Frequenz $f_{osc}$ des Referenztaktsignals gestellt, so dass sich die Frequenz $f_{in}$ des Eingangssignals ergibt zu

$$f_{in} = f_{osc} \: / \: (N1 + N2),$$

mit N1 als erstem Zählwert und N2 als zweitem Zählwert.

In einer Weiterbildung des Verfahrens kann zudem bestimmt sein, dass für die Frequenzbestimmung die Summe aus ersten und zweiten Zählwerten einer oder mehrerer solcher aufeinander folgender Messperioden im Eingangssignal verwendet wird. Beispielsweise kann festgelegt werden, dass eine bestimmte Anzahl von Messperioden im Eingangssignal für die Frequenzbestimmung herangezogen wird, so dass diese Anzahl aufeinander folgender erster Zählwerte und die entsprechende Anzahl zweiter Zählwerte aufaddiert werden, um aus der Frequenz des Referenztaktsignals den Wert der Frequenz des Eingangssignals zu bestimmen. Als Formel lässt sich dies beispielsweise ausdrücken durch

$$f_{in} = p \cdot f_{osc} \: / \: \sum (N1_i + N2_i),$$

mit p als Anzahl verwendeter Messperioden, mit $N1_i$ als erstem Zählwert einer i-ten Messperiode und mit $N2_i$ als zweitem Zählwert einer i-ten Messperiode.

Durch den größeren Messzeitraum in Eingangssignal wird die Genauigkeit der Frequenzbestimmung weiter erhöht, was die Zuverlässigkeit der bestimmten Frequenz verbessert.

In einer weiteren Ausführungsform des beschriebenen Verfahrens werden der erste Zählwert in einem ersten Zählvorgang und der zweite Zählwert in einem zweiten Zählvorgang bestimmt. Bei jedem dieser Zählvorgänge wird ein Zählerstand des jeweiligen Zählvorgangs bei jeder Taktflanke des Referenztaktsignals erhöht. Hierbei können entweder nur positive, ansteigende Taktflanken, negative, abfallende Taktflanken oder positive und negative Taktflanken des Referenztaktsignals gezählt werden. Der Zählwert, der jeweils in einem Zählvorgang bestimmt wird, kann durch einen momentanen Zählerstand des jeweiligen Zählvorgangs festgelegt werden oder durch den letzten Zählerstand, bevor sich das Eingangssignal in seinem Pegelwert ändert, also einem Zählergebnis für die jeweilige Pegelphase des Eingangssignals. Während eines Zählvorgangs, während das Eingangssignal einem der Pegelwerte entspricht, kann sich der jeweilige Zählwert mehrfach ändern, wobei in diesem Fall der Zählwert mit fortschreitendem Zählerstand stetig ansteigt. Der jeweilige Zählwert ist nicht größer als das Zählergebnis eines Zählvorgangs. Jeder Zählvorgang beginnt vorzugsweise mit dem Zählerstand 0.

In einer Weiterbildung der eben beschriebenen Ausführungsform wird der erste Zählwert durch ein Zählergebnis des ersten Zählvorgangs bestimmt, nachdem das Eingangssignal nicht mehr dem ersten Pegelwert entspricht. In ähnlicher Weise wird der zweite Zählwert durch ein Zählergebnis des zweiten Zählvorgangs bestimmt, nachdem das Eingangssignal nicht mehr dem zweiten Pegelwert entspricht. Dementsprechend werden der erste und der zweite Zählwert spätestens dann durch das Zählergebnis des jeweiligen Zählvorgangs, also den letzten Zählerstand des Zählvorgangs, bestimmt, wenn das Eingangssignal seinen Pegel gewechselt hat.

Zusätzlich hierzu kann der zweite Zählwert auch bestimmt werden durch einen momentanen Zählerstand beim zweiten Zählvorgang, wenn das Eingangssignal dem zweiten Pegelwert entspricht und dieser momentane Zählerstand einen Vergleichswert überschreitet. Anders ausgedrückt ist es möglich, dass bei der jeweiligen Festlegung des zweiten Zählwerts der zweite Zählvorgang noch nicht abgeschlossen ist, da das Eingangssignal dem zweiten Pegelwert noch entspricht. In der Anfangsphase des zweiten Zählvorgangs erfolgt keine neue Festlegung des zweiten Zählwerts. Sobald der momentane Zählerstand beim zweiten Zählvorgang aber den Vergleichswert überschreitet, nimmt der zweite Zählwert diesen Zählerstand an.

Durch die Festsetzung des zweiten Zählwerts, bevor der zweite Zählvorgang abgeschlossen ist, wird ermöglicht, dass eine näherungsweise Bestimmung der Frequenz durchgeführt werden kann. Der zweite Zählwert stellt in diesem Fall sozusagen einen Mindestwert für die zweite Pegelphase, während das Eingangssignal dem zweiten Pegelwert entspricht, dar, der kontinuierlich ansteigt, bis der zweite Zählvorgang wegen des Pegelwechsels im Eingangssignal beendet ist und der Zählwert dem Zählergebnis des zweiten Zählvorgangs entspricht. Die derart bestimmte Frequenz nähert sich also dem tatsächlichen Frequenzwert des Eingangssignals an und liefert früher ein zuverlässiges Ergebnis.

Der genannte Vergleichswert ergibt sich beispielsweise in Abhängigkeit des ersten Zählwerts oder des zweiten Zählwerts einer vorhergehenden Messperiode im Eingangssignal oder in Abhängigkeit von beiden vorgenannten Zählwerten. Beispielsweise kann angenommen werden, dass sich die Frequenz im Eingangssignal verringert, wenn bei einem Eingangssignal mit bekanntem Tastverhältnis nach einem aus dem ersten Zählwert errechenbaren Zählerstand beim zweiten Zählvorgang kein Pegelwechsel im Eingangssignal einstellt. In diesem Fall kann mit einer Annäherung der neuen Frequenz nach Erreichen des Vergleichswerts begonnen werden. Alternativ oder zusätzlich kann der zweite Zählwert der vorhergehenden Messperiode im Eingangssignal für die Bestimmung des Vergleichswerts herangezogen werden. Beispielsweise kann wiederum von einer Frequenzverringerung im Eingangssignal ausgegangen werden, wenn der momentane Zählerstand den vorhergehenden zweiten Zählwert erreicht und es noch zu keinem Pegelwechsel im Eingangssignal gekommen ist.

In die Bestimmung des Vergleichswerts können auch Toleranzwerte eingehen, die zusätzlich zu den vorgenannten Werten aus erstem Zählwert und vorhergehendem zweiten Zählwert herangezogen werden. Beispielsweise ergibt sich der Vergleichswert durch einen prozentualen Aufschlag auf einen aus erstem und/oder zweitem Zählwert errechneten Wert. Der Vergleichswert kann auch durch einen Größenvergleich des ersten Zählwerts und des vorhergehenden zweiten Zählwerts ermittelt werden, so dass nur der größere oder der kleinere der beiden als Vergleichswert verwendet wird.

Eine beispielhafte Ausführungsform einer Anordnung zur Frequenzbestimmung umfasst einen Eingang zur Zuführung eines Eingangssignals sowie einen ersten und einen zweiten Zähler. Der erste Zähler dient zum Zählen von Taktflanken eines Referenztaktsignals, während eines Zeitraums, in dem das Eingangssignal einem ersten Pegelwert entspricht. Dementsprechend dient der zweite Zähler zum Zählen von Taktflanken des Referenztaktsignals, während eines Zeitraums, in dem das Eingangssignal einem zweiten Pegelwert entspricht. Die Anordnung umfasst ferner eine Auswerteeinrichtung, die zur Bestimmung eines ersten und eines zweiten Zählwerts mit dem ersten und dem zweiten Zähler gekoppelt ist. Die Auswerteeinrichtung ist eingerichtet, eine Frequenz des Eingangssignals in Abhängigkeit des ersten und des zweiten Zählwerts zu bestimmen.

In verschiedenen Ausführungsformen der beschriebenen Anordnung ist die Auswerteeinrichtung der Anordnung dazu eingerichtet, die verschiedenen zuvor beschriebenen Ausgestaltungen des Verfahrens zur Frequenzbestimmung auszuführen.

Die Erfindung wird nachfolgend anhand von Ausführungsbeispielen mit Hilfe der Figuren näher erläutert. In den Figuren sind Signale und Elemente gleicher Art bzw. gleicher Funktion durch gleiche Bezugszeichen gekennzeichnet.

Es zeigen:

Fig. 1    ein Ausführungsbeispiel einer Anordnung zur Frequenzbestimmung, und

Fig. 2    ein beispielhaftes Signal-Zeit-Diagramm von Signalen innerhalb der Anordnung von Fig. 1.

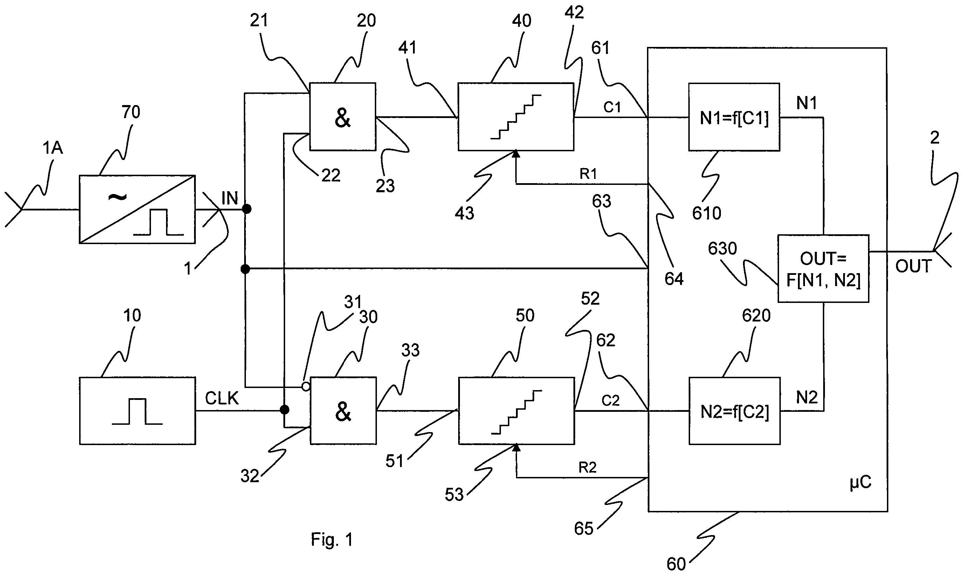

Fig.1 zeigt eine beispielhafte Anordnung zur Frequenzbestimmung, welche vorgesehen ist, eine Frequenz eines Eingangssignals IN, das an einem Eingang 1 anliegt, zu bestimmen. Die Anordnung umfasst ein erstes UND-Glied 20, ein zweites UND-Glied 30, einen ersten Zähler 40, einen zweiten Zähler 50 sowie eine Auswerteeinrichtung 60. Dem Eingang 1 der Anordnung ist eine Pulsformungseinrichtung 70 vorgeschaltet, die eingangsseitig mit einem Hilfseingang 1a gekoppelt ist. Ferner ist in der Fig. 1 ein Taktgenerator 10 dargestellt, der zur Erzeugung eines Referenztaktsignals CLK vorgesehen ist. Das erste UND-Glied 20 ist an seinem ersten Eingang 21 mit dem Eingang 1 und an einem zweiten Eingang 22 mit dem Taktgenerator 10 gekoppelt. Ein Ausgang 23 des UND-Glieds 20 ist an einen Eingang 41 des ersten Zählers 40 angeschlossen. In ähnlicher Weise ist das zweite UND-Glied 30 an seinem ersten Eingang 31, der als invertierender Eingang ausgeführt ist, mit dem Eingang 1 gekoppelt. Der zweite Eingang 32 des UND-Glieds 30 ist mit dem Taktgenerator 10 gekoppelt. Ein Ausgang 33 des UND-Glieds 30 ist an einen Eingang 51 des zweiten Zählers 50 angeschlossen.

Die Auswerteeinrichtung 60 weist einen ersten Zähleingang 61 auf, der mit einem Ausgang 42 des ersten Zählers 40 gekoppelt ist. Ferner ist bei der Auswerteeinrichtung 60 ein zweiter Zähleingang 62 vorgesehen, an den ein Ausgang 52 des zweiten Zählers 50 angeschlossen ist. Steueranschlüsse 64, 65 der Auswerteeinrichtung 60 sind mit Steuereingängen 43, 53 des ersten und zweiten Zählers 40, 50 gekoppelt. Die Auswerteeinrichtung 60 weist ferner einen Signaleingang 63 auf, der an den Eingang 1 angeschlossen ist. In der Auswerteeinrichtung 60 sind exemplarisch Auswerteblöcke 610, 620 dargestellt, die eingangsseitig mit dem ersten und zweiten Zähleingang 61, 62 verbunden sind. Ausgangsseitig sind die Blöcke 610, 620 mit einem weiteren Auswerteblock 630 gekoppelt, der ausgangsseitig an einen Ausgang 2 der Anordnung angeschlossen ist.

Der Taktgenerator 10 kann als Bestandteil der Anordnung zur Frequenzbestimmung ausgeführt sein. Alternativ wird das Referenztaktsignal CLK der Anordnung aber von extern zugeführt. Je nach gewünschter Genauigkeit kann der Taktgenerator 10 als Kristalloszillator, als LC-Schwingkreis oder als ein anderer bekannter Oszillator ausgeführt sein.

Im Betrieb der Anordnung wird über den Hilfseingang 1a ein Signal zugeführt, welches beispielsweise einen sinusförmigen Verlauf hat. In dem Pulsformer 70 wird beispielsweise aus dem eingangsseitig anliegenden Signal ein rechteckförmiges Signal erzeugt, welches zwei definierte Pegel aufweist. Dieses Signal dient als Eingangssignal IN für die Anordnung zur Frequenzbestimmung. In verschiedenen Ausführungsformen kann der Pulsformer 70 auch Bestandteil der Anordnung sein.

Das Eingangssignal IN wird dem ersten UND-Glied und, in invertierter Form, dem zweiten UND-Glied 30 zugeführt. Gleichzeitig liegt an den jeweils zweiten Eingängen 22, 32 des ersten und zweiten UND-Glieds 20, 30 das Referenztaktsignal CLK an. Dementsprechend werden vom ersten UND-Glied 20 Pulse des Referenztaktsignals CLK nur während der Zeiten am Ausgang 23 weitergegeben, während das Eingangssignal einem logischen High-Pegel entspricht. In ähnlicher Weise werden, wegen des invertierenden Eingangs 31, Taktflanken des Referenztaktsignals CLK am Eingang 32 nur dann an den Ausgang 33 weitergegeben, wenn das Eingangssignal IN einem logischen Low-Pegel entspricht.

Die Wahl von High-Pegel für das erste UND-Glied und Low-Pegel für das zweite UND-Glied kann in alternativen Ausführungsformen auch vertauscht werden. Grundsätzlich ist lediglich beabsichtigt, dass das Referenztaktsignal CLK für einen ersten Pegelwert an den Ausgang 23 weitergegeben wird und für einen zweiten Pegelwert an den Ausgang 33.

Die Zähler 40, 50 sind eingerichtet, Taktflanken des weitergeleiteten Referenztaktsignals CLK zu zählen und jeweils einen momentanen Zählerstand C1 bzw. C2 am Ausgang 42 bzw. 52 abzugeben. Als zu zählende Taktflanken können ansteigende, abfallende oder ansteigende und abfallende Taktflanken definiert werden. Die Auswerteblöcke 610, 620 sind zur Bestimmung eines ersten und eines zweiten Zählwerts M1, M2 aus dem eingangsseitig anliegenden Zählerstand C1, C2 eingerichtet. Der Auswerteblock 630 ist eingerichtet, aus dem ersten und zweiten Zählwert N1, N2 die Frequenz des Eingangssignal IN zu bestimmen und in geeigneter Form am Ausgang 2 als Ausgangssignal OUT abzugeben. In die Bestimmung der Zählwerte N1, N2 und des Ausgangssignals OUT kann auch der Pegelwert des Eingangssignals IN, das am Signaleingang 63 zugeführt wird, eingehen.

Über Steuersignale R1, R2 an den Steuerausgängen 64, 65 kann die Auswerteeinrichtung 60 die Zählerstände des ersten und zweiten Zählers 40, 50 auf einen Startwert, beispielsweise 0, zurücksetzen.

Die Frequenz des Eingangssignals IN kann auf verschiedene Weisen in der Auswerteeinrichtung 60 bestimmt werden. Grundsätzlich dient das jeweilige Ausgangssignal C1, C2 des ersten und zweiten Zählers 40, 50 als Grundlage zur Bestimmung des ersten und zweiten Zählwerts N1, N2. Zudem erfolgt die Frequenzbestimmung in Abhängigkeit des ersten und zweiten Zählwerts N1, N2, beispielsweise in Abhängigkeit der Summe des ersten und zweiten Zählwerts N1, N2. In verschiedenen Ausführungsformen kann die Auswerteeinrichtung 60 auch Zwischenspeicher oder Register aufweisen, in denen Zählwerte N1, N2 vorhergehender Messperioden gespeichert sind, wobei eine Messperiode im vorliegenden Anwendungsbeispiel als Aufeinanderfolge einer Low-Phase und einer High-Phase bzw. einer High-Phase und einer Low-Phase im Eingangssignal definiert ist. Die Frequenz kann in diesem Fall in Abhängigkeit der Summe aus ersten und zweiten Zählwerten einer oder mehrerer aufeinander folgender Messperioden im Eingangssignal bestimmt werden. Dies erhöht insbesondere die Zuverlässigkeit der Frequenzbestimmung, wenn die Bestimmung von der Bedingung abhängig gemacht wird, dass die Summe aus ersten und zweiten Zählwerten einer oder mehrerer aufeinander folgender Messperioden im Eingangssignal einen Grenzwert überschreitet, so dass der Frequenzbestimmung eine Mindestanzahl von gezählten Taktflanken im Referenztaktsignal CLK zugrunde gelegt wird.

Andere Ausgestaltungsformen für das Verfahren zur Frequenzbestimmung betreffen die Bestimmung des ersten und zweiten Zählwerts N1, N2. Grundsätzlich kann hierfür das Zählergebnis während einer Pegelphase im Eingangssignal IN, also der höchste Zählerstand des Zählers, während das Eingangssignal IN einem bestimmten Pegelwert entspricht, als Zählwert verwendet werden. Anders ausgedrückt, wird der Zählerstand des jeweiligen Zählers 40, 50 zum Zählwert N1, N2, wenn das Eingangssignal IN nicht mehr dem jeweils zugehörigen Pegelwert entspricht. Zusätzlich kann der zweite Zählwert derart bestimmt werden, das ein momentaner Zählerstand C2 des zweiten Zählers 50 verwendet wird, wenn das Eingangssignal IN dem entsprechenden Pegelwert entspricht und dieser momentane Zählerstand C2 einen Vergleichswert überschreitet. Dieser Vergleichswert kann sich beispielsweise aus dem momentan vorliegenden ersten Zählwert N1 ermitteln lassen. Alternativ oder zusätzlich kann auch der zweite Zählwert aus einer vorhergehenden Frequenzbestimmung des Eingangssignals IN für die Festlegung des Vergleichswerts herangezogen werden.

In ähnlicher Weise kann in alternativen oder zusätzlichen Ausführungsformen auch ein momentaner Zählerstand C1 des ersten Zählers 40 für die Festlegung des ersten Zählwerts N1 verwendet werden.

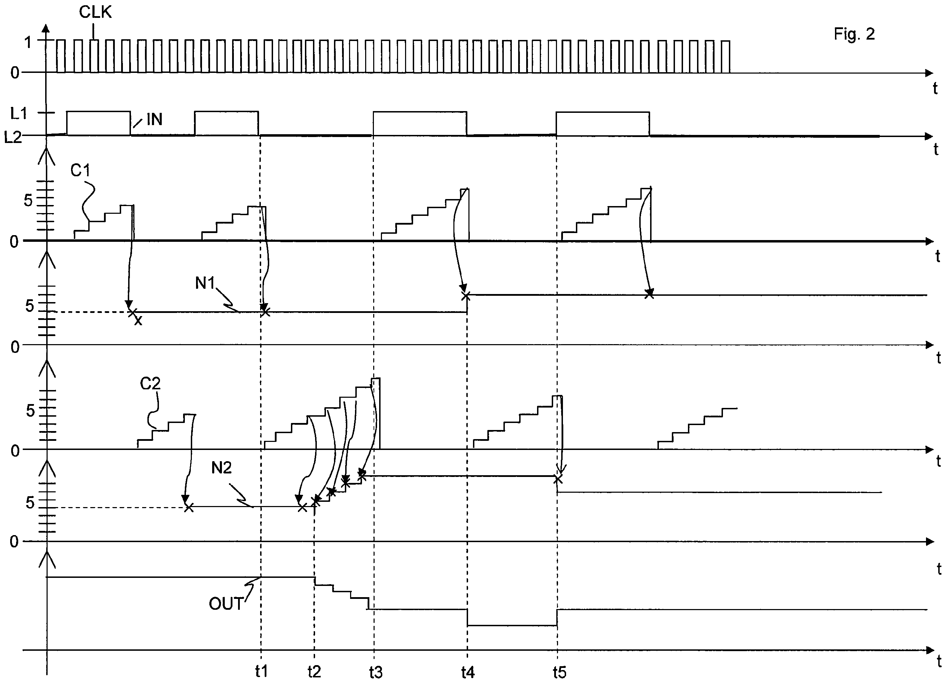

Fig. 2 zeigt ein beispielhaftes Signalzeitdiagramm von verschiedenen Signalen innerhalb der Anordnung von Fig. 1. Dargestellt sind u.a. das Referenztaktsignal CLK, das rechteckförmig mit einer festen Referenzfrequenz schwingt, sowie ein Eingangssignal IN, das abwechselnd einen ersten Pegelwert L1 und einen zweiten Pegelwert L2 annimmt. Im vorliegenden Beispiel ändert das Eingangssignal IN im Zeitraum t1 bis t3 seine Frequenz.

Ferner ist der erste Zählerstand C1 des ersten Zählers 40 dargestellt, der während der High-Phasen des Eingangssignals IN positive Taktflanken des Referenztaktsignals CLK zählt, also während der Pegelphasen, während derer das Eingangssignal IN dem ersten Pegelwert L1 entspricht. Zu den Zeitpunkten, an denen das Eingangssignal IN seinen Pegel vom ersten Pegelwert L1 zum zweiten Pegelwert L2, dem Low-Pegel, ändert, beispielsweise zu den Zeitpunkten t1 und t4, wird der Zählerstand C1 als Zählwert N1 übernommen. Dies ist insbesondere zum Zeitpunkt t4 deutlich sichtbar, bei dem sich der erste Zählwert N1 von vier auf sechs ändert.

Weiterhin ist in Fig. 2 der Zählerstand C2 des zweiten Zählers 50 dargestellt, welcher während des Signalpegels L2 des Eingangssignals IN positive Taktflanken des Referenztaktsignals CLK zählt. Beim zeitlich ersten dargestellten Zählvorgang des zweiten Zählers 50, der bis zum Zählerstand 4 läuft, wird dieser Zählerstand als zweiter Zählwert N2 zum Zeitpunkt übernommen, bei dem das Eingangssignal IN wieder auf den High-Pegel L1 wechselt. Beim zweiten Zählvorgang des zweiten Zählers 50 wird der Zählerstand C2 ab dem Wert 4 als zweiter Zählwert N2 übernommen. Zudem wird der Zählerstand in diesem Zählvorgang auch für die weiteren Erhöhungen des Zählerstands als zweiter Zählwert N2 übernommen, so dass dieser stufenweise auf den Wert acht ansteigt. Dieser höhere Zählwert N2 zum Zeitpunkt t3 ist bedingt durch die längere Low-Phase des Eingangssignals IN zwischen t1 und t3. Eine Übernahme des Zählerstands C2 als Zählwert N2 ab dem Wert vier ist beispielsweise bedingt durch den vorhergehenden Zählwert N2 aus dem ersten Zählvorgang.

Im darauf folgenden, dritten Zählvorgang des zweiten Zählers 50 endet der Zählvorgang zum Zeitpunkt t5 mit dem Zählergebnis 6, welches dann als zweiter Zählwert N2 übernommen wird.

Das als unterstes dargestellte Ausgangssignal OUT, welches die bestimmte Frequenz präsentiert, basiert beispielsweise auf der bekannten Frequenz $f_{osc}$ des Referenztaktsignals CLK geteilt durch die Summe der Zählwerte N1, N2. Dementsprechend fällt der Ausgangswert im Zeitraum t2 bis t3 bei konstantem ersten Zählwert N1 und ansteigendem zweiten Zählwert N2 stufenweise ab und nähert sich der tatsächlichen Frequenz des Eingangssignals an. Im Zeitraum t4 bis t5 sinkt das Ausgangssignal OUT wegen des gestiegenen ersten Zählwerts N1 weiter ab und nimmt zum Zeitpunkt t5 mit dem neuen zweiten Zählwert N2 einen der Eingangsfrequenz entsprechenden Wert an.

Es ist zu beachten, dass das in Fig. 2 dargestellte Signal-Zeit-Diagramm nur exemplarischen Charakter hat. Insbesondere sind aus Übersichtsgründen keine größeren Zählerstände dargestellt, die bei einer praktischen Anwendung die Genauigkeit des Verfahrens zur Frequenzbestimmung weiter erhöhen könnten. Beispielsweise kann festgelegt werden, dass eine bestimmte Anzahl von Messperioden im Eingangssignal für die Frequenzbestimmung herangezogen wird, so dass diese Anzahl aufeinander folgender erster Zählwerte und die entsprechende Anzahl zweiter Zählwerte aufaddiert werden, um die Frequenz des Eingangssignals zu bestimmen.

Das Ausgangssignal OUT kann von der Auswerteeinrichtung 60, die beispielsweise als Mikrocontroller ausgeführt ist, als analoger Wert ausgegeben werden. Beispielsweise erfolgt eine Ausgabe als Stromwert im Bereich von 4 bis 20 Milliampere oder als Spannungswert im Bereich von 0 bis 10 Volt. Alternativ kann das Ausgangssignal OUT auch als Rechtecktakt mit einer dem Eingangssignal entsprechenden Frequenz ausgegeben werden, wobei vorzugsweise hierfür ein einstellbarer Teiler verwendet wird.

Eine Anordnung und ein Verfahren wie oben beschrieben lassen sich zum Beispiel in einem Relais zur Schwellwertsignalisierung verwenden.

## Patentansprüche

1. Verfahren zur Bestimmung einer Frequenz eines Eingangssignals (IN), umfassend

    - Bestimmen eines ersten Zählwerts (N1) durch Zählen von Taktflanken eines Referenztaktsignals (CLK) während das Eingangssignal (IN) einem ersten Pegelwert (L1) entspricht;
    - Bestimmen eines zweiten Zählwerts (N2) durch Zählen von Taktflanken des Referenztaktsignals (CLK) während das Eingangssignal (IN) einem zweiten Pegelwert (L2) entspricht; und
    - Bestimmen der Frequenz in Abhängigkeit des ersten und des zweiten Zählwerts (N1, N2);
    wobei die Frequenzbestimmung in Abhängigkeit der Summe aus ersten und zweiten Zählwerten einer oder mehrerer aufeinanderfolgender Messperioden im Eingangssignal (IN) erfolgt; und
    wobei die Frequenz erst bestimmt wird, wenn die Summe aus ersten und zweiten Zählwerten einer oder mehrerer aufeinanderfolgender Messperioden im Eingangssignal (IN) einen Grenzwert überschreitet.

2. Verfahren nach Anspruch 1, bei dem die Frequenzbestimmung in Abhängigkeit der Summe des ersten und des zweiten Zählwerts (N1, N2) erfolgt.

3. Verfahren nach Anspruch 1oder 2, bei dem der erste Zählwert (N1) in einem ersten Zählvorgang und der zweite Zählwert (N2) in einem zweiten Zählvorgang bestimmt werden.

4. Verfahren nach Anspruch 3, bei dem

    - der erste Zählwert (N1) bestimmt wird durch ein Zählergebnis des ersten Zählvorgangs bei einem Pegelwechsel des Eingangssignals (IN), insbesondere wenn das Eingangssignal (IN) nicht mehr dem ersten Pegelwert (L1) entspricht; und
    - der zweite Zählwert (N2) bestimmt wird durch ein Zählergebnis des zweiten Zählvorgangs bei dem Pegelwechsel des Eingangssignals (IN), insbesondere nachdem das Eingangssignal (IN) nicht mehr dem zweiten Pegelwert (L2) entspricht.

5. Verfahren nach Anspruch 4, bei dem der zweite Zählwert (N2) bestimmt wird durch einen momentanen Zählerstand beim zweiten Zählvorgang, wenn das Eingangssignal (IN) dem zweiten Pegelwert (L2) entspricht und dieser momentane Zählerstand einen Vergleichswert überschreitet.

6. Verfahren nach Anspruch 5, bei dem sich der Vergleichswert in Abhängigkeit wenigstens eines der folgenden ergibt:

    - des ersten Zählwerts (N1);
    - des zweiten Zählwerts (N2) einer vorhergehenden Messperiode im Eingangssignal (IN).

**7.** Anordnung zur Frequenzbestimmung, umfassend

- einen Eingang (1) zur Zuführung eines Eingangssignals (IN);
- einen ersten Zähler (40) zum Zählen von Taktflanken eines Referenztaktsignals (CLK) während das Eingangssignal (IN) einem ersten Pegelwert (L1) entspricht;
- einen zweiten Zähler (50) zum Zählen von Taktflanken des Referenztaktsignals (CLK) während das Eingangssignal (IN) einem zweiten Pegelwert (L2) entspricht;
- eine Auswerteeinrichtung (60), die zur Bestimmung eines ersten und eines zweiten Zählwerts (N1, N2) mit dem ersten und dem zweiten Zähler (40, 50) gekoppelt ist und eingerichtet ist, eine Frequenz des Eingangssignals (IN) in Abhängigkeit des ersten und des zweiten Zählwerts (N1, N2) zu bestimmen;
wobei die Auswerteeinrichtung (60) eingerichtet ist, die Frequenz des Eingangssignals (IN) in Abhängigkeit der Summe aus ersten und zweiten Zählwerten einer oder mehrerer aufeinanderfolgender Messperioden im Eingangssignal (IN) zu bestimmen; und
wobei die Auswerteeinrichtung (60) eingerichtet ist, die Frequenz des Eingangssignals (IN) erst dann zu bestimmen, wenn die Summe aus ersten und zweiten Zählwerten einer oder mehrerer aufeinanderfolgender Messperioden im Eingangssignal (IN) einen Grenzwert überschreitet.

**8.** Anordnung nach Anspruch 7, bei der die Auswerteeinrichtung (60) eingerichtet ist, die Frequenz des Eingangssignals (IN) in Abhängigkeit der Summe des ersten und des zweiten Zählwerts (N1, N2) zu bestimmen.

**9.** Anordnung nach Anspruch 7 oder Anspruch 8, bei der die Auswerteeinrichtung (60) eingerichtet ist, den ersten und den zweiten Zählwert (N1, N2) derart zu bestimmen, dass der erste Zählwert (N1) bestimmt ist durch ein Zählergebnis des ersten Zählers (40) nachdem das Eingangssignal (IN) nicht mehr dem ersten Pegelwert (L1) entspricht und der zweite Zählwert (N2) bestimmt ist durch ein Zählergebnis des zweiten Zählers (50) nachdem das Eingangssignal (IN) nicht mehr dem zweiten Pegelwert (L2) entspricht.

**10.** Anordnung nach Anspruch 9, bei der die Auswerteeinrichtung (60) eingerichtet ist, den zweiten Zählwert (N2) derart zu bestimmen, dass der zweite Zählwert (N2) bestimmt ist durch einen momentanen Zählerstand des zweiten Zählers (50), wenn das Eingangssignal (IN) dem zweiten Pegelwert (L2) entspricht und dieser momentane Zählerstand einen Vergleichswert überschreitet.

**11.** Anordnung nach Anspruch 10, bei der sich der Vergleichswert in Abhängigkeit wenigstens eines der folgenden ergibt:

- des ersten Zählwerts (N1);
- des zweiten Zählwerts (N2) einer vorhergehenden Frequenzbestimmung des Eingangssignals (IN).

**Claims**

**1.** A method for determining a frequency of an input signal (IN) comprising

- determining a first count value (N1) by counting clock edges of a reference clock signal (CLK) while the input signal (IN) corresponds to a first level value (L1);
- determining a second count value (N2) by counting clock edges of the reference clock signal (CLK) while the input signal (IN) corresponds to a second level value (L2); and
- determining the frequency as a function of the first and the second count values (N1, N2); and
wherein the frequency is determined as a function of the sum of the first and second count values of one or more successive measuring periods in the input signal (IN); and
wherein the frequency is only determined when the sum of the first and second count values of one or more successive measuring periods in the input signal (IN) exceeds a limit.

**2.** The method as claimed in claim 1, wherein the frequency is determined as a function of the sum of the first and the second count value (N1, N2).

**3.** The method as claimed in claim 1 or 2, wherein the first count value (N1) is determined in a first count operation, and the second count value (N2) in a second count operation.

**4.** The method as claimed in claim 3, wherein

- the first count value (N1) is determined by a counter result of the first count operation on a level change of the input signal (IN), in particular when the input signal (IN) no longer corresponds to the first level value; and
- the second count value (N2) is determined by a counter result of the second count operation on the level change of the input signal (IN) in particular when the input signal (IN) no longer corresponds to the second level value (L2).

**5.** The method as claimed in claim 4, wherein the second count value (N2) is determined by an instantaneous counter status in the second count operation when the input signal (IN) corresponds to the second level value (L2) and this instantaneous counter status exceeds a comparison value.

**6.** The method as claimed in claim 5, wherein the comparison value is given as a function of at least one of the following:

- the first count value (N1);
- the second count value (N2) of a previous measuring period in the input signal (IN).

**7.** An arrangement for determining frequency, comprising:

- an input (1) for feeding in an input signal (IN);
- a first counter (40) for counting clock edges of a reference clock signal (CLK) while the input signal (IN) corresponds to a first level value (L1);
- a second counter (50) for counting clock edges of the reference clock signal (CLK) while the input signal (IN) corresponds to a second level value (L2); and
- an evaluation unit (60), which is coupled to the first and the second counter (40, 50) in order to determine a first and a second count value (N1, N2), and is set up to determine a frequency of the input signal (IN) as a function of the first and the second count value (N1, N2);
wherein the evaluation unit (60) is set up to determine the frequency of the input signal (IN) as a function of the sum of the first and second count values of one or more successive measuring periods in the input signal (IN); and
wherein the evaluation unit (60) is set up to determine the frequency of the input signal (IN) only when the sum of the first and second count values of one or more successive measuring periods in the input signal (IN) exceeds a limit.

**8.** The arrangement as claimed in claim 7, wherein the evaluation unit (60) is set up to determine the frequency of the input signal (IN) as a function of the sum of the first and the second count value (N1, N2).

**9.** The arrangement as claimed in claim 7 or 8, wherein the evaluation unit (60) is set up to determine the first and the second count value (N1, N2) in such a way that the first count value (N1) is determined by a counter result of the first counter (40) when the input signal (IN) no longer corresponds to the first level value (L1) and the second count value (N2) is determined by a counter result of the second counter (50) when the input signal (IN) no longer corresponds to the second level value (L2).

**10.** The arrangement as claimed in claim 9, wherein the evaluation unit (60) is set up to determine the second count value (N2) in such a way that the second count value (N2) is determined by an instantaneous counter status of the second counter (50) when the input signal (IN) corresponds to the second level value (L2) and this instantaneous counter status exceeds a comparison value.

**11.** The arrangement as claimed in claim 10, wherein the comparison value is given as a function of at least one of the following:

- the first count value (N1);
- the second count value (N2) of a previous determination of the frequency of the input signal (IN).

## Revendications

**1.** Procédé de détermination d'une fréquence d'un signal d'entrée (IN), comprenant les étapes consistant en

- la détermination d'une première valeur de comptage (N1) par le comptage de fronts d'horloge d'un signal d'horloge de référence (CLK) tandis que le signal d'entrée (IN) correspond à une première valeur de niveau (L1) ;
- la détermination d'une deuxième valeur de comptage (N2) par le comptage de fronts d'horloge du signal d'horloge de référence (CLK) tandis que le signal d'entrée (IN) correspond à une deuxième valeur de niveau (L2) ; et
- la détermination de la fréquence en fonction de la première et de la deuxième valeur de comptage (N1, N2) ;
la détermination de fréquence ayant lieu en fonction de la somme des première et deuxième valeurs de comptage d'une ou plusieurs périodes de mesure successives dans le signal d'entrée (IN) ; et
la fréquence n'étant déterminée que lorsque la somme des première et deuxième valeurs de comptage d'une ou plusieurs périodes de mesure successives dans le signal d'entrée (IN) dépasse une valeur limite.

**2.** Procédé selon la revendication 1, dans lequel la détermination de fréquence a lieu en fonction de la somme des première et deuxième valeurs de comptage (N1, N2).

**3.** Procédé selon la revendication 1 ou 2, dans lequel la première valeur de comptage (N1) est déterminée dans un premier processus de comptage et la deuxième valeur de comptage (N2) est déterminée dans un deuxième processus de comptage.

4. Procédé selon la revendication 3, dans lequel

- la première valeur de comptage (N1) est déterminée par un résultat de comptage du premier processus de comptage lors d'un changement de niveau du signal d'entrée (IN), plus particulièrement lorsque le signal d'entrée (IN) ne correspond plus à la première valeur de niveau (L1) ; et
- la deuxième valeur de comptage (N2) est déterminée par un résultat de comptage du deuxième processus de comptage lors du changement de niveau du signal d'entrée (IN), plus particulièrement après que le signal d'entrée (IN) ne corresponde plus à la deuxième valeur de niveau (L2).

5. Procédé selon la revendication 4, dans lequel la deuxième valeur de comptage (N2) est déterminée par un état de comptage instantané lors du deuxième processus de comptage lorsque le signal d'entrée (IN) correspond à la deuxième valeur de niveau (L2) et cet état de comptage dépasse une valeur de comparaison.

6. Procédé selon la revendication 5, dans lequel la valeur de comparaison résulte d'un des éléments suivants :

- la première valeur de comptage (N1) ;
- la deuxième valeur de comptage (N2) d'une période de mesure précédente dans le signal d'entrée (IN).

7. Agencement pour la détermination de fréquence, comprenant

- une entrée (1) pour l'introduction d'un signal d'entrée (IN) ;
- un premier compteur (40) pour le comptage de fronts d'horloge d'un signal d'horloge de référence (CLK) tandis que le signal d'entrée (IN) correspond à une première valeur de niveau (L1) ;
- un deuxième compteur (50) pour le comptage de fronts d'horloge du signal d'horloge de référence (CLK) tandis que le signal d'entrée (IN) correspond à une deuxième valeur de niveau (L2) ;
- un dispositif d'analyse (60), qui, pour la détermination d'une première et d'une deuxième valeurs de comptage (N1, N2), est couplé avec les premier et deuxième compteurs (40, 50) et qui est conçu pour déterminer une fréquence du signal d'entrée (IN) en fonction des première et deuxième valeurs de comptage (N1, N2) ;

le dispositif d'analyse (60) étant conçu pour déterminer la fréquence du signal d'entrée (IN) en fonction de la somme des première et deuxième valeurs de comptage d'une ou plusieurs périodes de mesures successives dans le signal d'entrée (IN) ; et
le dispositif d'analyse (60) étant conçu pour ne déterminer la fréquence du signal d'entrée (IN) que lorsque la somme des première et deuxième valeurs de comptage d'une ou plusieurs périodes de mesures successives dans le signal d'entrée (IN) dépasse une valeur limite.

8. Agencement selon la revendication 7, dans lequel le dispositif d'analyse (60) est conçu pour déterminer la fréquence du signal d'entrée (IN) en fonction de la somme des première et deuxième valeurs de comptage (N1, N2).

9. Agencement selon la revendication 7 ou la revendication 8, dans lequel le dispositif d'analyse (60) est conçu pour déterminer les première et deuxième valeurs de comptage (N1, N2) de façon que la première valeur de comptage (N1) soit déterminée à l'aide d'un résultat de comptage du premier compteur (40) après que le signal d'entrée (IN) ne corresponde plus à la première valeur de niveau (L1) et que la deuxième valeur de comptage (N2) soit déterminée à l'aide d'un résultat de comptage du deuxième compteur (50) après que le signal d'entrée (IN) ne corresponde plus à la deuxième valeur de niveau (L2).

10. Agencement selon la revendication 9, dans lequel le dispositif d'analyse (60) est conçu pour déterminer la deuxième valeur de comptage (N2) de façon que la deuxième valeur de comptage (N2) soit déterminée à l'aide d'un état de comptage instantané du deuxième compteur (50) lorsque le signal d'entrée (IN) correspond à la deuxième valeur de niveau (L2) et cet état de comptage instantané dépasse une valeur de comparaison.

11. Agencement selon la revendication 10, dans lequel la valeur de comparaison résulte d'au moins un des éléments suivants :

- la première valeur de comptage (N1) ;
- la deuxième valeur de comptage (N2) d'une détermination de fréquence précédente du signal d'entrée (IN).

Fig. 1

Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4609990 A
- US 5095264 A